Europäisches Patentamt

European Patent Office

Office européen des brevets

(19)

(11) Publication number: **0 109 125**
**A2**

(12) # EUROPEAN PATENT APPLICATION

(21) Application number: **83201592.9**

(22) Date of filing: **08.11.83**

(51) Int. Cl.³: **H 03 K  19/177, H 03 K  19/096**

(30) Priority: **10.11.82 GB 8232138**

(43) Date of publication of application: **23.05.84**
**Bulletin 84/21**

(84) Designated Contracting States: **DE FR GB IT NL**

(71) Applicant: **PHILIPS ELECTRONIC AND ASSOCIATED INDUSTRIES LIMITED, Arundel Great Court 8 Arundel Street, London WC2R 3DT (GB)**
(84) Designated Contracting States: **GB**

(71) Applicant: **N.V. Philips' Gloeilampenfabrieken, Groenewoudseweg 1, NL-5621 BA Eindhoven (NL)**
(84) Designated Contracting States: **DE FR IT NL**

(72) Inventor: **Brewer, Robert John, c/o MULLARD SOUTHAMPTON MILLBROOK IND. ESTATE, Southampton Hants SO9 7BH (GB)**

(74) Representative: **Moody, Colin James et al, Philips Electronic and Associated Industries Limited Patent Department Mullard House Torrington Place, London WC1E 7HD (GB)**

(54) **Logic circuit array.**

(57)   By using de  Morgan's theorem, Boolean algebra equations can be converted so that it is possible to design a compact logic array in which the capacitive nodes within the array may be precharged directly rather than through the logic FETs. In consequence a logic array can be fabricated to implement the converted equations, which array can be operated at higher speeds than known circuits for substantially the same power consumption or, conversely, at the same speed as the known circuits with a substantially lower power consumption.

**EP 0 109 125 A2**

"LOGIC CIRCUIT ARRAY"

The present invention relates to a logic circuit array which can be implemented as an integrated circuit.

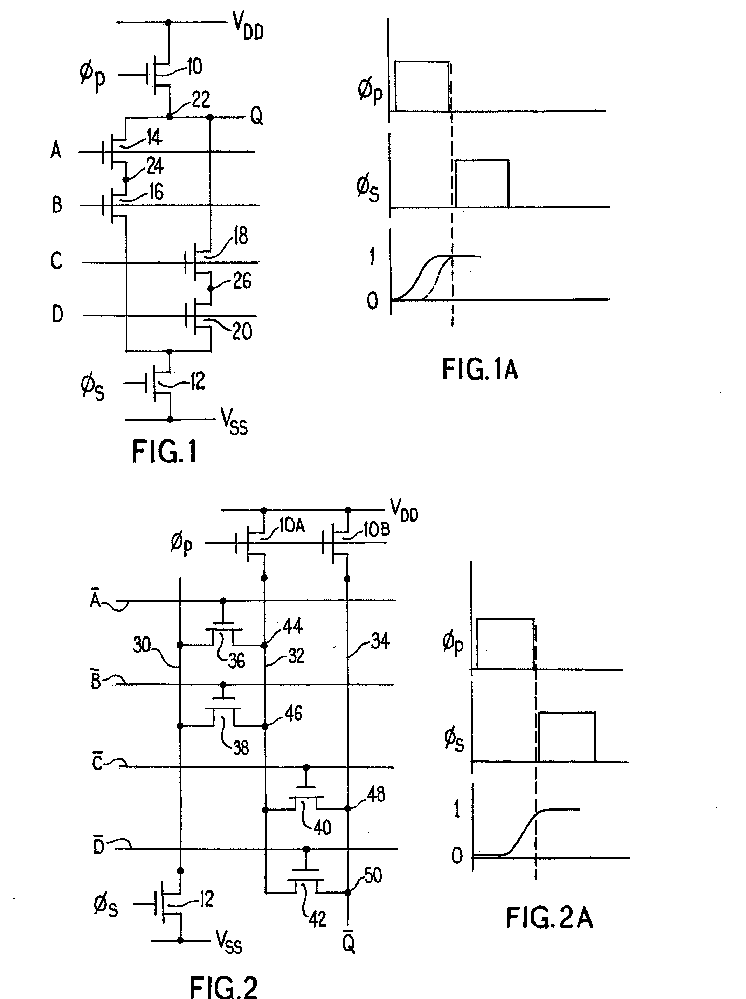

In order to carry out a logic function such as $Q = (A * B) + (C * D)$, where in Boolean algebra $*$ means AND and $+$ means OR, usually a circuit is fabricated comprising two sticks of transistors for respectively carrying out the AND operations of each of the expressions shown in brackets, which sticks of transistors are connected in parallel between a precharging transistor and a sampling transistor which are clocked at non-overlapping time periods. A drawback to this known type of circuit, which is described later in greater detail with reference to Figure 1 of the accompanying drawings, is that it is necessary for the data signals to become true early-on in the precharging period otherwise there is a risk of a degraded "high" output being produced. Consequently a speed limitation exists which can only be overcome by reducing the signal propagation delay or rise times, which in turn means a higher power consumption where the signals are generated by depletion load logic, and this leads to a power dissipation problem.

Accordingly it is an object of the present invention to be able to operate a logic circuit at a higher speed than is possible with the known circuit without increasing the power consumption or, conversely, to operate it at the same speed with a reduced power consumption.

According to the present invention there is provided a logic circuit array comprising a plurality of transistors arranged in at least two series connected groups, the conductivity paths of the transistors in each group being arranged in parallel, control electrodes of the transistors being respectively connected to data input lines, nodes formed by junctions of the groups, the nodes being prechargeable in use, one end of the series connected groups in use being pulled-down to a low voltage at least at preselected intervals, and the other end of the series connected groups constituting an output of the array.

The present invention is based on the recognition of the fact that by using de Morgan's theorem, AND functions in Boolean algebra may be converted into NOR functions, and OR functions into NAND functions.

In one embodiment of the present invention the precharging of the nodes is controllable by at least one clocked transistor. Also said one end of the series connected groups is connected to a transistor whose control electrode is clocked at selected sampling intervals. Providing controlled sampling of the logic circuit array saves power because there need never be a DC current path between $V_{DD}$ and $V_{SS}$, although this is done at the expense of speed of operation because the output does not begin to come true until the rising edge of the sample clock, rather than when all the data inputs are true.

In another embodiment of a logic circuit array in accordance with the present invention, two smaller arrays are arranged back to back with said one end of each array being connected to a common pull-down line and with the other ends of each array being coupled to respective inputs of a static logic circuit. By using smaller arrays connected as described rather than one large array having a large number of series connected transistors between the output and the pull-down line, the discharge time is kept short which otherwise could become a more serious speed limitation than the data delay and rise times of the prior art circuit.

The present invention also relates to an integrated circuit including the logic circuit array.

The present invention will now be explained and described, by way of example, with reference to the accompanying drawings, wherein

Figure 1 is a schematic circuit diagram of a known logic circuit,

Figure 1A shows three timing diagrams to illustrate the operation of the circuit shown in Figure 1,

Figure 2 is a schematic circuit diagram of an embodiment of a logic circuit diagram made in accordance with the present invention,

Figure 2A shows three timing diagrams to illustrate the operation of the circuit shown in Figure 2,

Figure 3 shows an embodiment of an implementation of the matrix part of the logic circuit of Figure 2 as an integrated circuit,

Figure 4 is a schematic circuit diagram of another embodiment of a logic circuit diagram made in accordance with the present invention, and

Figure 5 is a diagrammatic implementation of the matrix part of the circuit shown in Figure 4 as an integrated circuit.

In order to explain and describe the invention a logic circuit for solving the Boolean algebra equation

$$Q = \overline{(A * B) + (C * D)}$$

will be considered.

A known dynamic circuit for solving this equation is illustrated in Figure 1. The circuit is implemented using n-type enhancement mode, insulated gate, field effect transistors (FETs). The circuit comprises a precharging FET 10 whose drain is connected to a supply rail $V_{DD}$, a sampling FET 12 whose source is connected to another supply rail $V_{SS}$, and two sticks of pairs of series connected FETs 14, 16 and 18, 20, respectively, connected in parallel between the source of FET 10 and the drain of FET 12. A node 22 between the source of FET 10 and the parallel sticks constitutes the output Q. A precharging clock signal $\phi_p$ is applied to the gate of the FET 10 and a sampling clock signal $\phi_s$ is applied to the gate of the FET 12, the clock

signals $\phi_p$ and $\phi_s$ are non-coincident as shown in the
waveform diagram referenced Figure 1A. Data signals A, B,
C and D are applied respectively to the gates of the FETs
14, 16, 18 and 20.

In operation when the clock signal $\phi_p$ goes high, the
capacitance at the node 22 is charged to near $V_{DD}$. When the clock
signal $\phi_s$ goes high after the clock signal $\phi_p$ has gone low,
the output Q is dependent on the condition of the signals
A to D. For example if the signals A to D are low or the
signals applied to at least one of the FETs in each stick is
low then Q will be high. However if A and B or C and D are
high, then the charge at the node 22 will flow away to $V_{SS}$
via the FETs which are conductive thus making Q go low.

A limitation of this known circuit arises because if
the data signals A to D are to go high then they should change
from low to high fairly early in the period of the precharge
clock signal $\phi_p$ thus ensuring that precharging of a node 24 or
26 is effected so that at the occurrence of the sampling pulse
$\phi_s$ a good high can be produced on the output Q. Now if one or
other of the signals A or C goes high very late in the period of
the clock signal $\phi_p$, for example as shown in broken lines in the
third diagram in Figure 1A, then the node 24 or 26 will not be
charged to near $V_{DD}$. Hence when the precharging clock signal
$\phi_p$ goes low, charge will be shared between the node 22 and the node
24 or 26 and a very poor high will result at the output Q. Whilst
this problem of the late data signals could be resolved with very
fast data changes this involves a high power consumption which is
very undesirable if the circuit is implemented as an integrated
circuit because of the problem of heat dissipation.

Figure 2 illustrates an embodiment of a logic circuit which
can carry out the equivalent logic function and which is tolerant
to the data signals A to D becoming true just before the end of
$\phi_p$. In accordance with de Morgan's theorem, the Boolean equation

$$Q = \overline{(A * B) + (C * D)} \qquad\qquad (1)$$

can be rewritten as:

$$Q = \overline{\overline{(\overline{A} + \overline{B})} + \overline{(\overline{C} + \overline{D})}} \qquad (2)$$

$$Q = (\overline{A} + \overline{B}) * (\overline{C} + \overline{D}) \qquad (3)$$

Figure 2 shows an implementation of the inverse of equation (3). The circuit illustrated comprises a matrix of horizontal and vertical conductors. The horizontal conductors are data lines and for convenience will be referenced by the data they are carrying $\overline{A}$, $\overline{B}$, $\overline{C}$ and $\overline{D}$. The vertical lines 30, 32 and 34 are linking lines. Precharging FETs 10A and 10B have their source-drain paths connected between the lines 32 and 34 and the supply rail $V_{DD}$. A sampling FET 12 has its drain-source path connected between the line 30 and the supply rail $V_{SS}$. FETs 36 and 38 have their respective source-drain paths connected between the lines 30 and 32 and their gates connected respectively to the data lines $\overline{A}$ and $\overline{B}$. In a similar manner the source-drain paths of the FETs 40 and 42 are connected between the lines 32 and 34 and their gates are connected respectively to the lines $\overline{C}$ and $\overline{D}$. The output $\overline{Q}$ of the circuit is derived from the line 34.

In operation when the precharging clock signal $\phi_p$ is applied to the gates of the FETs 10A and 10B, nodes 44, 46, 48 and 50 are precharged independently of the value of the data signals on the data lines $\overline{A}$, $\overline{B}$, $\overline{C}$, $\overline{D}$. When the sampling clock signal $\phi_s$ is applied to the gate of FET 12 the line 30 is pulled-down to $V_{SS}$ and the output $\overline{Q}$ is dependent on the data signals. Thus if $\overline{A}$ or $\overline{B}$ and $\overline{C}$ or $\overline{D}$ are high then there will be a conductive path to $V_{SS}$ and the nodes 44, 46, 48, 50 will be discharged. However if $\overline{A}$ and $\overline{B}$ and/or $\overline{C}$ and $\overline{D}$ are both low then the charge on the nodes 48 and 50 will remain and a good high is produced on the output $\overline{Q}$. Since the precharging of the nodes 44, 46, 48 and 50 is independent of the conductivity of the FETs 36, 38, 40 and 42 during the precharging clock signal $\phi_p$ period then the

0109125
PHB 32928 EP

data signals $\bar{A}$, $\bar{B}$, $\bar{C}$ and $\bar{D}$ can become true just before the sampling clock signal $\emptyset_s$ without affecting the operation of the logic circuit. This means that the circuit of Figure 2 can be operated substantially faster than the circuit of Figure 1 without any necessity to increase the power consumption in the circuitry generating the data signals which is important when integrating such circuits. There is one disadvantage to this type of layout which is that the vertical linking lines 30, 32 and 34 prevent the running across of arrays of unrelated metal signal lines. Thus although some chip area will be lost in implementing the circuit of Figure 2 compared with the circuit of Figure 1, obtaining a speed increase of the order of 3 without any increase in power consumption or, conversely, since speed and power are interrelated, obtaining the same speed for about a third of the power consumption, more than offsets this disadvantage.

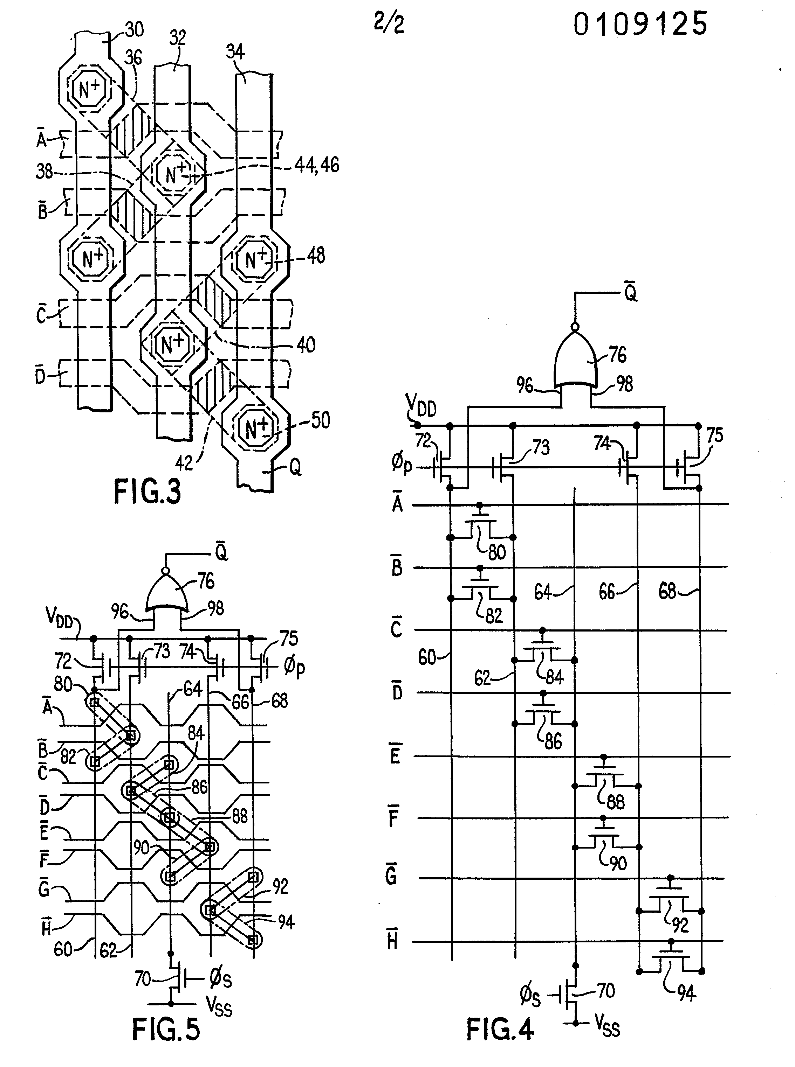

Figure 3 shows an implementation of the matrix part of Figure 2 as MOS integrated circuit. Without going into great detail on the actual process, which is known per se in the art, the circuit is fabricated in a series of stages with one layer overlying another. $N^+$ regions are formed in a $P^-$ substrate (not shown) at predetermined locations. The data lines $\bar{A}$, $\bar{B}$, $\bar{C}$ and $\bar{D}$ are formed by lines of polysilicon extending generally transversely of Figure 3. The linking lines 30, 32 and 34 of metal, e.g. aluminium, extend vertically of Figure 3. The MOS transistors 36, 38, 40 and 42 are each formed by a diffusion path shown in chain-dot lines extending between two $N^+$ regions with an insulated gate, shown in hatched lines, therebetween. The nodes 44, 46, 48 and 50 are formed by the capacitance existing between the $N^+$ region and its adjacent line 32 or 34.

If the speed of the logic operation is more important than the saving in power then the transistor 12 may be omitted.

Figure 4 illustrates an enlargement of the logic circuit of Figure 2. By de Morgan's theorem the Boolean algebra equation

$$Q = (A * B) + (C * D) + (E * F) + (G * H) \qquad (4)$$

can be rewritten as:

$$Q = \overline{(\overline{A} + \overline{B})} + \overline{(\overline{C} + \overline{D})} + \overline{(\overline{E} + \overline{F})} + \overline{(\overline{G} + \overline{H})} \qquad (5)$$

and equation (5) can be rewritten as:

$$Q = \overline{\left[(\overline{A} + \overline{B}) * (\overline{C} + \overline{D})\right]} + \overline{\left[(\overline{E} + \overline{F}) * (\overline{G} + \overline{H})\right]} \qquad (6)$$

Thus the slow AND functions in equation (4) have been converted into faster NOR functions.

Figure 4 shows an implementation of the inverse ($\overline{Q}$) of equation (6) which can be fabricated with good packing density using the technique illustrated in Figure 3 and shown diagrammatically in Figure 5. In Figure 4 the horizontal lines are for the data signals $\overline{A}$ to $\overline{H}$ and the vertical lines 60, 62, 64, 66 and 68 are linking lines. Pairs of FETs 80 and 82, 84 and 86, 88 and 90 and 92 to 94 have their source-drain paths connected between pairs of the linking lines 60, 62; 62, 64; 64, 66; and 66, 68, respectively. The gates of these FETs are connected to their respective data lines $\overline{A}$ to $\overline{H}$. Thus when the precharging clock signal $\phi_p$ is high the internal capacitive nodes between the FETs 80 to 94 and the linking lines 60, 62, 66 and 68 are precharged directly to nearly $V_{DD}$. Because the nodes are precharged independently of the logic FETs 80 to 94 the data lines $\overline{A}$ to $\overline{H}$ need only be true just before the sampling clock signal $\phi_s$ goes high hence allowing for longer propagation delays and slower rise times in the data. In Figure 4 when the sampling clock signal $\phi_s$ goes high, the linking line 64 is pulled down to $V_{SS}$ and the logical result of the left-hand part of the matrix portion of the circuit appears on the input 96 of the NOR gate 76 whilst the logical result of the right-hand part appears on the input 98 of the NOR gate 76, the output $\overline{Q}$ being the inverse of equation (6). The drain-source path of a sampling FET 70 is connected between the line 64 and $V_{SS}$ and the drain-source paths of precharging FETs 72, 73, 74 and 75 are connected between $V_{DD}$ and the respective linking lines 60, 62, 66 and 68. For convenience of reference the matrix portion of the illustrated circuit may be regarded as being two parts which are symmetrical about the linking line 64. The lines 60, 68 constitute the output line of each part and are connected to respective inputs 96, 98 of a static NOR gate 76 on which the output $\bar{Q}$ is produced.

In operation the gates of the FETs 72 to 75 are clocked by the precharging clock signal $\phi_p$ and that of the FET 70 is clocked by the sampling signal $\phi_s$ which is not coincident with $\phi_p$.

Figure 5 illustrates diagrammatically how the matrix part of Figure 4 can be implemented as an integrated circuit using the technique described with reference to Figure 3.

It is estimated that by implementing the inverse of equation (6) in the manner described compared with implementing equation (4) in accordance with the principles of Figure 1, that either a speed increase of $2\frac{1}{2}$ times is achieved for the same power consumption or for the same speed a $2\frac{1}{2}$ times reduction in power consumption is achieved.

In general a Boolean function containing in its fully expanded form any number of bracketed AND-groups may be reduced to a number of smaller arrays whose outputs are logically combined with a NOR gate in a way similar to the simple example shown in Figure 4. This keeps the array discharge time short, which because of the series connection of transistors between the $\bar{Q}$ output and the pull-down to $V_{SS}$ could otherwise become a more serious speed limitation than the data delay and rise times and associated power dissipation problem, the alleviation of which is the main purpose of this invention.

0109125
PHB 32928EP

CLAIMS:

1. A logic circuit array characterised by a plurality of transistors arranged in at least two series connected groups, the conductivity paths of the transistors in each group being arranged in parallel, control electrodes of the transistors being respectively connected to data input lines, nodes formed by junctions of the groups, the nodes being prechargeable in use, one end of the series connected groups in use being pulled-down to a low voltage at least at preselected intervals, and the other end of the series connected groups constituting an output of the array.

2. A logic array as claimed in Claim 1, characterised in that the precharging of the nodes is controllable by at least one transistor which is clocked at predetermined intervals.

3. A logic array as claimed in Claim 1 or 2, characterised in that the one end of the series connected groups is connected to a transistor whose control electrode is clocked at selected sampling intervals.

4. A logic circuit array characterised by two logic arrays as claimed in Claim 1 arranged back to back with said one end of each array being connected to a common pull-down line and with the other ends of each array being coupled to respective inputs of a static logic circuit.

5. An integrated circuit including the logic circuit array as claimed in any one of Claims 1 to 4.

FIG.1

FIG.1A

FIG.2

FIG.2A

FIG.3

FIG.5

FIG.4